(19) Europäisches Patentamt
European Patent Office
Office européen des brevets

(11) **EP 2 375 879 A1**

(12) **EUROPEAN PATENT APPLICATION**
published in accordance with Art. 153(4) EPC

(43) Date of publication:
**12.10.2011 Bulletin 2011/41**

(51) Int Cl.:
**H05K 3/34** (2006.01)  **B32B 27/00** (2006.01)

(21) Application number: **09834446.8**

(22) Date of filing: **22.12.2009**

(86) International application number:
**PCT/JP2009/007145**

(87) International publication number:
**WO 2010/073639 (01.07.2010 Gazette 2010/26)**

(84) Designated Contracting States:
**AT BE BG CH CY CZ DE DK EE ES FI FR GB GR HR HU IE IS IT LI LT LU LV MC MK MT NL NO PL PT RO SE SI SK SM TR**

(30) Priority: **26.12.2008 JP 2008331699**

(71) Applicant: **Sumitomo Bakelite Company Limited Shinagawa-ku Tokyo 140-0002 (JP)**

(72) Inventors:
• **KATSURAYAMA, Satoru**
  **Tokyo 140-0002 (JP)**
• **MAEJIMA, Kenzou**
  **Tokyo 140-0002 (JP)**
• **FUJII, Tomoe**
  **Tokyo 140-0002 (JP)**

(74) Representative: **Vossius, Corinna et al**
  **Dr. Volker Vossius**
  **Patent- und Rechtsanwaltskanzlei**
  **Geibelstrasse 6**
  **81679 München (DE)**

(54) **FLEXIBLE SUBSTRATE AND ELECTRONIC DEVICE**

(57)     A flexible substrate 10 of the present invention is the flexible substrate comprising a first resin film 1 having flux activity and a second resin film 2 different from the first resin film 1 laminated to said first resin film. The flexible substrate 10 is **characterized in that** the flexible substrate 10 is used by having a plurality of electronic components mounted on the surface of the first resin film 1, and thereafter having the respective electronic components and the flexible substrate 10 bonded at one time. The gel time of the first resin film 1 at 230˚C is 100 seconds or more and 600 seconds or less.

[Fig. 1]

**Description**

TECHNICAL FIELD

The present invention relate to a flexible substrate and an electronic device.

BACKGROUND ART

In recent years, there are some remarkable technological innovations for semiconductor packages to be lighter, thinner, shorter and smaller. The semiconductor packages having various structures have been made into products. For such semiconductor package products, in place of a conventional lead frame bonding method, a flip chip mounting method that enables a direct vertical connection has been considered particularly important (refer to, for example, Patent Document 1).

In late years, with the spread of cellular telephones and mobile type electronic devices, reduction in size and thickness particularly for a semiconductor package has been in progress, but the quantity of information and communication, and the quantity of stored information have been rather increased. Thus, wiring for performing exchange of electronic information in such a semiconductor package has been taken a step forward to fine wiring. Usually, flip chip type packages are used to constitute a semiconductor device by connecting bumps formed of a solder or the like and an organic or inorganic rigid substrate subjected to wiring process. However, in order to make clear a target requiring extreme thinning and finer wiring, there have also been limitations from the standpoints of technique and cost.

Then, there has been known a technique using a flexible substrate in place of a rigid substrate. According to this technique, there has been known that semiconductor components and a flexible substrate are bonded using a resin film. In this case, segmented semiconductor chips have generally been bonded to a flexible substrate (refer to Patent Document 2).

RELATED DOCUMENTS

PATENT DOCUMENTS

Patent Document 1: Japanese Patent Application Laid-Open No. Hei9 (1997)-246326
Patent Document 2: Japanese Patent Application Laid-Open No. 2005-116624

DISCLOSURE OF THE INVENTION

However, improvement of the yield rate higher than the above related arts has been in demand.
An object of the present invention is to provide a flexible substrate capable of providing an electronic device capable of forming fine wiring with a high yield rate.
Moreover, another object of the present invention is to provide an electronic device capable of forming fine wiring with a high yield rate.
These objects of the present invention are attained by the matters described in the following (1) to (13).

(1) A flexible substrate comprising a first resin film having flux activity and a second resin film different from the first resin film laminated to the first resin film, wherein the flexible substrate is used by having a plurality of electronic components mounted on the surface of the first resin film, and thereafter having the respective electronic components and the flexible substrate bonded at one time, and a gel time of the first resin film at 230°C is 100 seconds or more and 600 seconds or less.

(2) The flexible substrate according to (1), wherein the reduction retention rate of the first resin film calculated according to an equation 1 from the amount of the acid measured under the following condition is not less than 15%,

[Measurement Condition]

0.1 g to 0.2 g of the first resin film subjected to heat treatment at 100°C for 30 minutes and the first resin film without heat treatment are respectively accurately weighed, and dissolved in 100 ml of acetone to perform a titration with an aqueous sodium hydroxide solution in accordance with a potential difference measuring method for calculating the molar amount (mol/g) of the acid per unit weight,

[Equation 1]

Reduction Retention Rate (%) = {(Amount of acid in the first resin film subjected to heat treatment at 100°C for 30 minutes)/(Amount of acid in the first resin film without heat treatment)} × 100

(3) The flexible substrate according to (1) or (2), wherein the first resin film is composed of a resin composition containing a thermosetting resin and a compound having flux activity.

(4) The flexible substrate according to any one of (1) to (3), wherein the first resin film contains phenolphthalin.

(5) The flexible substrate according to any one of (1) to (4), wherein the melt viscosity of the first resin film at 120˚C is 0.1 to 10,000 Pa·s.

(6) The flexible substrate according to any one of (1) to (5), wherein the melt viscosity of the first resin film at 120˚C is 1 to 10,000 Pa·s.

(7) The flexible substrate according to any one of (1) to (6), wherein the second resin film is provided with through holes and the through holes are each filled with a conductor member.

(8) The flexible substrate according to any one of (1) to (7), wherein conductor layers are formed on one surface of the second resin film, and bump electrodes are formed on the other surface thereof so as to cover the conductor members.

(9) The flexible substrate according to any one of (1) to (8), wherein the second resin film is composed of at least one resin selected among a polyimide type resin, a polyester type resin, a polyamide type resin and a liquid crystal polymer.

(10) The flexible substrate according to any one of (1) to (9), wherein the coefficient of thermal expansion the second resin film at room temperature (23˚C) or more and the glass transition temperature of the second resin film or less is not more than 15 ppm.

(11) The flexible substrate according to any one of (1) to (10), wherein the coefficient of thermal expansion the second resin film at room temperature (23˚C) or more and the glass transition temperature of the second resin film or less is 3 ppm or more and 8 ppm or less.

(12) An electronic device comprising the flexible substrate according to any one of (1) to (11).

(13) A method for producing an electronic device comprising mounting a plurality of electronic components on a surface of a first resin film of a flexible substrate obtained by laminating the first resin film having flux activity and a second resin film different from the first resin film, and thereafter bonding the respective electronic components and the flexible substrate bonded at one time, and segmenting the plurality of electronic components together with the flexible substrate into pieces after the bonding step, in which the flexible substrate is the flexible substrate according to any one of (1) to (11).

According to the present invention, it is possible to obtain a flexible substrate capable of providing an electronic device capable of forming fine wiring with a high yield rate.

Also, according to the present invention, it is possible to obtain an electronic device capable of forming fine wiring with a high yield rate.

BRIEF DESCRIPTION OF THE DRAWINGS

The above and other objects, features and advantages will be apparent from the following detailed description of the preferred embodiments in conjunction with the accompanying drawings.

Fig. 1 is a cross-sectional view illustrating one example of a flexible substrate.
Fig. 2 is a cross-sectional view illustrating a method for producing a semiconductor device.
Fig. 3 is a cross-sectional view illustrating a method for producing a semiconductor device.

DESCRIPTION OF EMBODIMENTS

Hereinafter, the flexible substrate and the electronic device of the present invention will be described.

The flexible substrate of the present invention is a flexible substrate obtained by laminating a first resin film having flux activity and a second resin film different from the first resin film. The flexible substrate is used by having a plurality of electronic components mounted on the surface of the first resin film, and thereafter having the respective electronic components and the flexible substrate bonded at one time.

The gel time of the first resin film at 230˚C is 100 seconds or more and 600 seconds or less.

Furthermore, the electronic device of the present invention has the flexible substrate described above.

First, the flexible substrate will be described with reference to appropriate drawings.

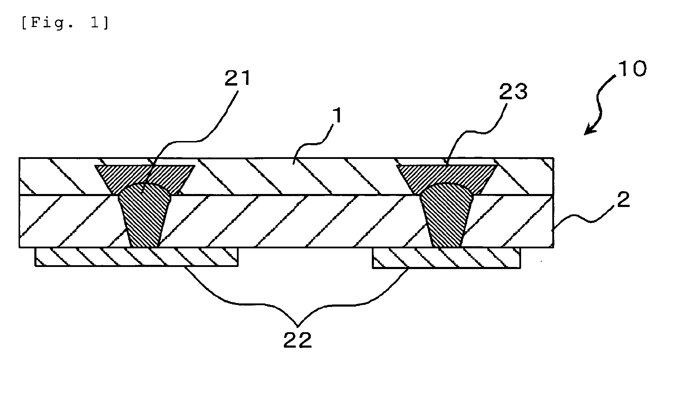

Fig. 1 is a cross-sectional view illustrating one example of a flexible substrate.

As shown in Fig. 1, a flexible substrate 10 is a laminate of a first resin film 1 having flux activity and a second resin film 2 different from the first resin film 1.

Through holes (not illustrated) are formed on the second resin film 2, and the through holes are each filled with a conductor member 21.

Furthermore, conductor layers 22 are formed on one surface of the second resin film 2 (lower surface in Fig. 1).

Moreover, bump electrodes 23 are formed on the other surface of the second resin film 2 so as to cover the conductor members 21 (upper surface in Fig. 1).

The first resin film 1 is laminated on the second resin film 2 so as to cover the bump electrodes 23.

First Resin Film

Such a first resin film is composed, for example, of a resin composition containing a thermoplastic resin and a resin having flux activity, a resin composition containing a thermosetting resin, a compound having flux activity and a film-forming resin, or the like. Among these, the first resin film is preferably composed of a resin composition containing a thermosetting resin, a compound having flux activity and a film-forming resin. Thus, the first resin film is excellent in heat resistance to heat treatment such as solder reflow or the like.

Examples of the thermosetting resin include an epoxy resin, an oxetane resin, a phenol resin, a (meth) acrylate resin, an unsaturated polyester resin, a diallyl phthalate resin, a maleimide resin and the like. Among these resins, preferably used is an epoxy resin. The epoxy resin is suitably used as a thermosetting resin in view of excellent curability and storage stability, and excellent heat resistance, moisture resistance and chemical resistance of a cured product.

The content of the thermosetting resin is preferably 20 to 80 % by weight and particularly preferably 30 to 70 % by weight based on the total amount of the aforementioned resin composition. When the content is within the above range, excellent curability is achieved, and excellent melting behavior can also be designed.

The aforementioned compound having flux activity is capable of reducing an oxide film formed on the surface of solder bumps upon the melting of the resin composition, thus enhancing wettability of a solder component constituting the solder bumps, and lowering a connection resistance value between opposing internal electrodes in a semiconductor chip.

Examples of the flux activating compound include compounds having a phenolic hydroxyl group, a carboxyl group or the like.

Examples of the compound having a phenolic hydroxyl group include monomers each having a phenolic hydroxyl group such as phenol, o-cresol, 2,6-xylenol, p-cresol, m-cresol, o-ethylphenol, 2,4-xylenol, 2,5-xylenol, m-ethylphenol, 2,3-xylenol, meditol, 3,5-xylenol, p-tert-butylphenol, catechol, p-tert-amylphenol, resorcinol, p-octylphenol, p-phenylphenol, bisphenol A, bisphenol F, bisphenol AF, biphenol, diallyl bisphenol F, diallyl bisphenol A, trisphenol, tetrakisphenol and the like; phenol novolac resins; o-cresol novolac resins; bisphenol F novolac resins; bisphenol A novolac resins and the like.

Examples of the compound having a carboxyl group include aliphatic acid anhydride, alicyclic acid anhydride, aromatic acid anhydride, aliphatic carboxylic acid, aromatic carboxylic acid, phenol and the like.

Here, examples of the aliphatic acid anhydride include succinic acid anhydride, polyadipic acid anhydride, polyazelaic acid anhydride, polysebacic acid anhydride and the like.

Examples of the alicyclic acid anhydride include methyl tetrahydrophthalic acid anhydride, methyl hexahydrophthalic acid anhydride, methyl himic acid anhydride, hexahydrophthalic acid anhydride, tetrahydrophthalic acid anhydride, trialkyl tetrahydrophthalic acid anhydride, methyl cyclohexene dicarboxylic acid anhydride and the like.

Examples of the aromatic acid anhydride include phthalic acid anhydride, trimellitic acid anhydride, pyromellitic acid anhydride, benzophenone tetracarboxylic acid anhydride, ethylene glycol bistrimellitate, glycerol tristrimellitate and the like.

Examples of the aliphatic carboxylic acid include formic acid, acetic acid, propionic acid, butyric acid, valeric acid, pivalic acid, caproic acid, caprylic acid, lauric acid, myristic acid, palmitic acid, stearic acid, acrylic acid, methacrylic acid, crotonic acid, oleic acid, fumaric acid, maleic acid, oxalic acid, malonic acid, succinic acid, glutaric acid, adipic acid, sebacic acid, dodecanedioic acid, pimelic acid and the like. Among these, suitably used is an aliphatic carboxylic acid represented by $HOOC\text{-}(CH_2)_n\text{-}COOH$ (n is an integer of 0 to 20), and preferably used are adipic acid, sebacic acid

EP 2 375 879 A1

and dodecanoic acid.

Examples of the aromatic carboxylic acid include benzoic acid, phthalic acid, isophthalic acid, terephthalic acid, hemimellitic acid, trimellitic acid, trimesic acid, mellophanic acid, prehnitic acid, pyromellitic acid, mellitic acid, triilic acid, xylic acid, hemelitic acid, mesitylenic acid, prehnitylic acid, toluic acid, cinnamic acid, salicylic acid, 2,3-dihydroxybenzoic acid, 2,4-dihydroxybenzoic acid, gentisic acid (2,5-dihydroxybenzoic acid), 2,6-dihydroxybenzoic acid, 3,5-dihydroxybenzoic acid, gallic acid (3,4,5-trihydroxybenzoic acid), naphthoic acid derivatives such as 1,4-dihydroxy-2-naphthoic acid, 3,5-dihydroxy-2-naphthoic acid, 3,5-2-dihydroxy-2-naphtoic acid and the like; phenolphthalin; diphenolic acid, and the like.

Among these flux activating compounds, preferably used is a compound capable of acting as a curing agent of the aforementioned thermosetting resin (a curing agent having flux activity). That is, the aforementioned flux activating compound exhibits an action of reducing an oxide film formed on the surface of solder bumps to such an extent that it is possible to bond the electrical connections to the conductor member, and is preferably a compound having a functional group that is bound to a resin component (a curing agent having flux activity). For example, when the resin component contains an epoxy resin, a curing agent having flux activity may have a carboxyl group and a group reacting with an epoxy group (for example, a carboxyl group, a hydroxyl group, an amino group and the like).

Such a curing agent having flux activity exhibits an action of reducing the oxide film formed on the surface of solder bumps during solder connection to such an extent that it is possible to bond the electrical connections to the conductor member, and is incorporated into a resin skeleton during a curing reaction thereafter. Accordingly, a process of cleaning for flux removal can be omitted.

Examples of the aforementioned film-forming resin include a (meth)acrylic resin, a phenoxy resin, a polyester resin, a polyurethane resin, a polyimide resin, a siloxane-modified polyimide resin, polybutadiene, polypropylene, a styrene-butadiene-styrene copolymer, a styrene-ethylene-butylene-styrene copolymer, a polyacetal resin, a polyvinyl butyral resin, a polyvinyl acetal resin, a butyl rubber, a chloroprene rubber, a polyamide resin, an acrylonitrile-butadiene copolymer, an acrylonitrile-butadiene-acrylic acid copolymer, an acrylonitrile-butadiene-styrene copolymer, polyvinyl acetate, nylon and the like. These may be used singly or may be used in combination of two or more kinds. Above all, preferably used is at least one kind selected from the group consisting of a (meth)acrylic resin, a phenoxy resin and a polyimide resin.

The weight average molecular weight of the aforementioned film-forming resin is not particularly limited, but it is preferably not less than 100,000, more preferably 150,000 to 1,000,000, and further preferably 250,000 to 900,000. When the weight average molecular weight is within the above range, film-forming properties may further be improved.

The content of the aforementioned film-forming resin is not particularly limited, but it is preferably 10 to 50 % by weight, more preferably 15 to 40 % by weight and particularly preferably 20 to 35 % by weight, based on the total amount of the aforementioned resin composition. When the content is within the above range, the fluidity of the resin component before melting of an adhesive film may be suppressed, and handling of the adhesive film is facilitated.

Moreover, examples of the thermoplastic resin when the first resin film is composed of a resin composition containing a thermoplastic resin and a compound having flux activity include general-purpose resins such as polyethylene (PE), polystyrene (PS), polypropylene (PP), an acrylonitrile-styrene resin (AS resin), an acrylonitrile-butadiene resin (AB resin), an acrylonitrile-butadiene-styrene resin (ABS resin), polybutadiene, a methacrylic resin, vinyl chloride and the like; general-purpose engineering plastics such as polyamide, polyacetal, polyethylene terephthalate (PET), ultra-high molecular weight polyethylene, polybutylene terephthalate (PBT), methylpentene, polybenzoxazole, polyethylene phthalate, polyester, polycarbonate and the like; and high heat-resistant super-engineering resins such as polyimide (PI), polyphenylene sulfide (PPS), polyetheretherketone (PEEK), a liquid crystal polymer (LCP), polytetrafluoroethylene (PTFE), polyetherimide (PEI), polyarylate (PAR), polysulfone (PSF), polyethersulfone (PES), polyamideimide (PAI), a nylon resin and the like.

Furthermore, examples of the compound having flux activity are the same as those described above.

The aforementioned resin composition may further contain an additive such as a coupling agent, a curing accelerator, a filler, a surface active agent or the like, in addition to the aforementioned thermosetting resin, the film-forming resin and the flux activating compound.

The first resin film can be obtained, for example, by applying the aforementioned resin composition to a base material and drying it.

The thickness of the first resin film 1 is not particularly limited, but it is preferably 1 to 80 $\mu$m and particularly preferably 5 to 50 $\mu$m. When the thickness is within the above range, both gap filling properties (making a gap between objects to be connected formed of electrodes of a semiconductor component without any cavity or air trapping) and creeping properties onto the semiconductor components (during the connection, the resin film is excessively flowing up to the semiconductor components due to the flow of the resin film, so that a connecting equipment is contaminated) are excellent.

The melt viscosity of the first resin film 1 at 120°C is preferably 0.1 to 10,000 Pa·s, more preferably 1 to 10,000 Pa·s and particularly preferably 1 to 100 Pa·s. When the melt viscosity is within the above range, particularly the connectivity (solder connectivity) of electrodes of a semiconductor component is excellent.

Furthermore, the aforementioned melt viscosity can be evaluated, for example, at a temperature increase rate of 10˚C/minute using a rheometer (a product of Haake Co., Ltd.).

The lower limit of the gel time of the first resin film 1 at 230˚C is preferably not less than 100 seconds and particularly preferably not less than 120 seconds. Furthermore, the upper limit thereof is preferably not more than 600 seconds and particularly preferably not more than 500 seconds. Accordingly, the gel time is most preferably 120 to 500 seconds.

Hereinafter, technical meaning of specifying the gel time of the first resin film 1 to the above range will be described. When the semiconductor components are respectively bonded to a flexible substrate, in order to improve the productivity, the gel time needs to be shortened. However, when a plurality of semiconductor components are bonded to a flexible substrate, a heat accompanied for temporary connection of one of semiconductor components is also thermally conducted to the bonding portions of other adjacent temporarily connected semiconductor components. When the gel time of the first resin film is short, curing of the first resin film during the temporary connection proceeds. Thus, there are problems such that the fluidity of the first resin film 1 is deteriorated during the bonding and an electrode connection failure takes place. On the other hand, when the gel time is within the above range, curing of the first resin film does not proceed during the temporary connection. So, an electrode connection failure hardly takes place and a semiconductor device excellent in connection reliability can be obtained.

Moreover, the aforementioned gel time can be evaluated, for example, by measuring the time period until no tackiness remains using a hot plate set to a temperature of 180˚C. Specifically, it can be measured in accordance with JIS C2161 7.5.2.

The reduction retention rate of the first resin film 1 is preferably not less than 15%, more preferably not less than 30% and particularly preferably not less than 50%. The upper limit is not particularly limited, but it is practically not more than 98%. The reduction retention rate can be calculated by the equation 1 from the amount of the acid measured under the following measurement condition.

[Measurement Condition]

0.1 g to 0.2 g of the aforementioned first resin film subjected to heat treatment at 100˚C for 30 minutes and the first resin film without heat treatment are respectively accurately weighed, and dissolved in 100 ml of acetone to perform a titration with an aqueous sodium hydroxide solution in accordance with a potential difference measuring method for calculating the molar amount (mol/g) of the acid per unit weight.

[Equation 1]

$$\text{Reduction Retention Rate (\%)} = \{(\text{Amount of acid in the first resin film subjected to heat treatment at } 100\text{˚C for } 30 \text{ minutes})/(\text{Amount of acid in the first resin film without heat treatment})\} \times 100$$

The reduction retention rate is calculated, for example, as the molar amount of the acid ($H^+$) per unit weight by a titration with 0.05 mol/l of an aqueous sodium hydroxide solution using an automatic potentiometric titrator (Model: AT-500N, a product of Kyoto Electronics Manufacturing Co., Ltd.), which is then put into the above equation 1.

In order to improve the reduction retention rate, it is preferable to select a compound in which protons derived from a carboxyl group or a phenolic hydroxyl group of the flux activating compound are hardly dissociated. Specifically, it is preferable to select a compound having a pKa value higher than 2,4-dihydroxycarboxylic acid. As the compound having flux activity, for example, phenolphthalin or 2,5-dihydroxybenzoic acid may be selected.

Hereinafter, technical meaning of specifying the reduction retention rate to the above range will be described. When a plurality of semiconductor components are bonded to a conventional flexible substrate, there has been a problem of occurring a bonding failure in the solder connection step. Although the reason is not quite clear, it is suggested that, as described above, a heat accompanied for temporary connection of one of semiconductor components is also thermally conducted to the bonding portions of other adjacent temporarily connected semiconductor components, whereby the compound having flux activity is reacted with the resin in the first resin film and the flux activity is deteriorated.

Then, the first resin film has the reduction retention rate as described above, whereby deterioration of the flux activity in the temporary connection step can be reduced and solders can be well connected.

Second Resin Film

Conductor layers 22 are formed on one surface of the second resin film 2 (lower surface in Fig. 1).
On the second resin film 2, through holes are formed by use of a laser or the like, and the through holes are each filled with the conductor member 21 by plating, a conductive paste or the like. Thus, one surface of the second resin film 2 can be electrically connected to the other surface through the conductor members 21.
Moreover, bump electrodes 23 are formed on the other surface of the second resin film by use of a solder or the like so as to cover the conductor members 21 (upper surface in Fig. 1).
The second resin film 2 is composed of a polyimide type resin such as a polyimide resin, a polyetherimide resin, a polyamideimide resin or the like; a polyamide type resin, a polyester type resin, or a resin such as a liquid crystal polymer or the like. Among these resins, the second resin film is preferably composed of at least one resin selected among a polyimide type resin, a polyester type resin, a polyamide type resin and a liquid crystal polymer. The second resin film is particularly preferably composed of a polyimide type resin. Thus, heat resistance can be enhanced. In addition to such a resin constituting a so-called flexible circuit board, a so-called build-up material such as a carrier-attached resin film or the like may be used as the second resin film 2 as long as it exhibits flexibility by lamination with the first resin film 1.
The coefficient of thermal expansion in the film in-plane direction of the second resin film 2 is not particularly limited, but it is preferably not more than 15 ppm, more preferably not more than 10 ppm and most preferably 3 to 8 ppm in the range of room temperature (23°C) or more the glass transition temperature of the second resin film 2 or less. When the coefficient of thermal expansion is within the above range, the difference in coefficient of thermal expansion between the electronic components and the second resin film 2 can be reduced, so that warpage in the resulting semiconductor devices can be reduced.
Incidentally, the coefficient of thermal expansion can be evaluated under the condition of a temperature increase rate of 10°C/minute in a tensile stress method using a thermo-mechanical analysis apparatus (TMA, SS6100, a product of Seiko Instruments Inc.).
The thickness of the second resin film 2 is not particularly limited, but it is preferably 10 to 200 $\mu$m and particularly preferably 20 to 100 $\mu$m. When the thickness is within the above range, flexibility and processability are excellent.
The flexible substrate 10 can be obtained by laminating the first resin film 1 and the second resin film 2.
The thickness of the flexible substrate 10 is not particularly limited either, but it is preferably 30 to 300 $\mu$m and particularly preferably 40 to 100 $\mu$m. When the thickness is within the above range, the thinning of a package is excellent.
Moreover, the ratio (t2/t1) of the thickness t2 of the second resin film 2 to the thickness t1 of the first resin film 1 in the flexible substrate 10 is not particularly limited, but it is preferably 0.1 to 10 and particularly preferably 0.5 to 1. When the ratio of the thicknesses is within the above range, warpage properties after lamination are particularly excellent.
The dielectric constant of the flexible substrate 10 (measurement frequency: 1 GHz) is not particularly limited, but it is preferably 2 to 5 and particularly preferably 2.5 to 4.5. When the dielectric constant is within the above range, electrical properties such as improvement of transmission efficiency of electrical signals are particularly excellent.

Method for Producing Electronic Component

(Semiconductor Device)

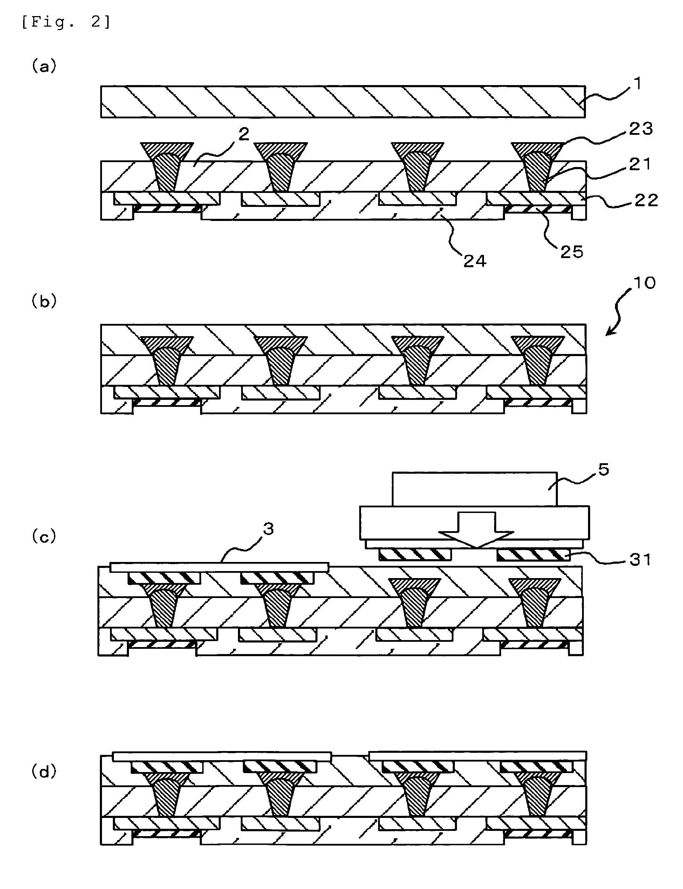

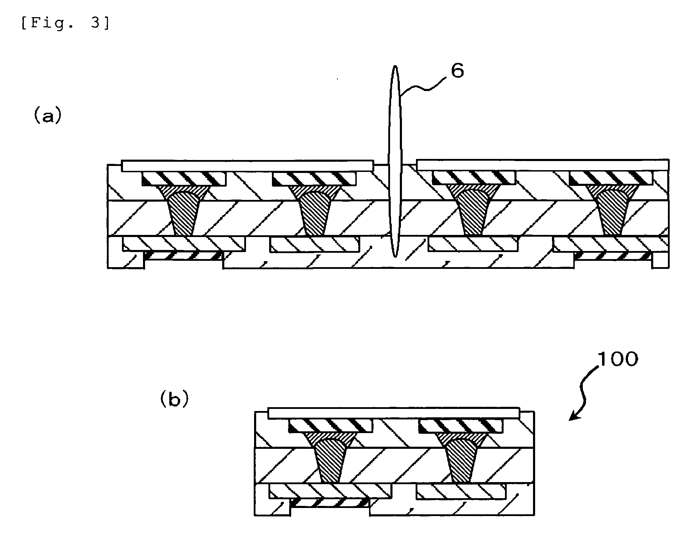

Next, a method for producing a semiconductor device as one example of the electronic components will be described based on a preferred embodiment with reference to Figs. 2 and 3. Incidentally, in the following description and drawings, the same or corresponding components are assigned the same reference numerals and overlapping explanations thereof will not be repeated.
First, conductor layers 22 and a solder resist 24 so as to cover the conductor layers 22 are formed on one surface of the second resin film 2 (lower surface in Fig. 2) (Fig. 2(a)).
Moreover, the solder resist 24 is removed partially to reveal the conductor layers 22, and pads 25 are installed on the solder resist-removed portions (Fig. 2(a)).
On the second resin film 2, through holes are formed, and the through holes are each filled with the conductor member 21 composed of a conductive paste (Fig. 2(a)).
Moreover, bump electrodes 23 are formed on the other surface of the second resin film 2 by use of a solder so as to cover the conductor members 21 (upper surface in Fig. 2) (Fig. 2(a)).
The flexible substrate (laminate) 10 is obtained by laminating the first resin film 1 on a side where the bump electrodes 23 of the second resin film 2 are formed (Fig. 2(b)).

Furthermore, in the embodiment, a case where the second resin film 2 having through holes has been described, but the present invention is not restricted thereto, and for example, it may be used for a single-sided wiring substrate such that electrical wiring is formed only on one surface.

Next, semiconductor chips 3 having bump electrodes 31 are aligned and mounted on the surface of the first resin film 1 in the laminate 10 using a flip chip bonder 5 (Fig. 2(c)). Thus, the bump electrodes 23 formed on the second resin film 2 are brought into contact with the bump electrodes 31 in the semiconductor chips 3 for temporary connection. In the method for producing a semiconductor device shown in Fig. 2, two semiconductor chips 3 are temporarily connected. Here, the conditions for temporary connection are not particularly limited, but the pressure is preferably 0.001 to 3 MPa, the temperature is preferably 20 to 200˚C and the time period is preferably 0.1 to 120 seconds, and the pressure is particularly preferably 0.02 to 1 MPa, the temperature is particularly preferably 50 to 100˚C and the time period is particularly preferably 0.3 to 60 seconds. Accordingly, the semiconductor components and the flexible substrate can be temporarily firmly attached without damaging the semiconductor chips 3 while suppressing curing of the first resin film 1.

Next, the flexible substrate 10 with which a plurality of semiconductor chips 3 are temporarily connected is heated, so that the bump electrodes 23 formed on the second resin film 2 and the bump electrodes 31 in the semiconductor chips 3 are electrically connected at one time (solder connection) (Fig. 2(d)). Thus, a plurality of semiconductor chips 3 and the second resin film 2 are electrically connected at one time.

The heating conditions are not particularly limited as long as the conditions allow the solder connection, but the conditions are different depending on the kind of solder in use. The temperature is preferably 1˚C to 50˚C higher than a melting point of the solder at actual temperature and the time period is preferably 1 to 120 seconds, and the temperature is particularly preferably 5˚C to 15˚C higher than a melting point of the solder and the time period is particularly preferably 5 to 60 seconds.

After the solder connection, the aforementioned first resin film 1 is thermally cured (post-cured). Thus, adhesion between the semiconductor chips 3 and the flexible substrate 10 can be enhanced, whereby the reliability can be enhanced. Furthermore, after thermal curing, the first resin film 1 is able to function as a encapsulating material between the solder connection portions, so that the reliability can be further enhanced.

The conditions for thermal curing are not particularly limited, but the temperature is preferably 100 to 200˚C and the time period is preferably 10 to 180 minutes, and the temperature is particularly preferably 120 to 185˚C and the time period is particularly preferably 30 to 90 minutes.

Subsequently, a semiconductor device 100 is obtained by cutting between the semiconductor chips 3 using a dicing blade 6 and segmenting components into pieces (Figs. 3(a) and (b)).

In this embodiment, a plurality of semiconductor chips 3 are bonded at one time, but the present invention is not limited thereto. After main semiconductor chips 3 are bonded at one time, other components may be mounted.

Since the semiconductor device can be obtained by using the flexible substrate 10 excellent in formability of the through holes by use of a laser or the like, the electronic device capable of forming fine wiring can be obtained.

Furthermore, since the flexible substrate 10 is composed of the first resin film of the thermosetting resin having flux activity, both of solder connectivity and adhesion are excellent.

Meanwhile, a plurality of semiconductor components are mounted and bonded at one time, so that the productivity is excellent.

EXAMPLES

The present invention is now illustrated in detail below with reference to Examples and Comparative Examples. However, the present invention is not restricted to these Examples.

Example 1

1. Production of Flexible Substrate

45 % by weight of an epoxy resin, EPICLON 840-S (a product of DIC Corporation), 24.9 % by weight of a phenoxy resin, YX6954 (a product of Japan Epoxy Resin Co., Ltd.), 15 % by weight of a compound having flux activity, phenolphthalin (a product of Tokyo Chemical Industry Co., Ltd.), 15 % by weight of a phenol novolac resin, PR-53647 (a product of Sumitomo Bakelite Co., Ltd.) and 0.1 % by weight of a curing accelerator, 2P4MZ (2-phenyl-4-methylimidazole, a product of Shikoku Chemicals Corporation) were previously mixed as the first resin film, and the mixture was applied to a polyethylene terephthalate base film to give a resultant material. The resultant material and a copper clad polyimide film with a two-layer structure obtained by thermocompression bonding a copper foil having a thickness of 12 $\mu$m to a polyimide base material (UPISEL-N, Model: SE1310, a product of UBE Industries, Ltd., thickness: 25 $\mu$m, coefficient of thermal expansion: 11 ppm) serving as the second resin film were laminated under the conditions of a temperature of 120˚C, a pressure of 2 kg/cm$^2$ and a lamination speed of 0.3 m/minute using a vacuum laminator, whereby a flexible substrate (thickness: 70 $\mu$m) was obtained. Incidentally, the gel time of the first resin film at 230˚C was 140 seconds, the melt viscosity at 120˚C was 50 Pa·s, and the reduction retention rate was 90%.

2. Production of Four Semiconductor Devices Bonded At One Time

Each of four semiconductor chips in total (size: 10 mm × 10 mm × 0.2 mm) having solder bumps with a height of 25 $\mu$m and a pitch of 70 $\mu$m was mounted on the surface of the first resin film in the obtained flexible substrate under the conditions of a temperature of 120˚C, a period of 10 seconds and a pressure of 0.1 MPa for temporary connection. Next, the semiconductor components were heated at 230˚C for 30 seconds for carrying out solder connection, which was then put into an oven and heated at 180 ˚C for 60 minutes for thermally curing the first resin film. Finally, four semiconductor devices were obtained by cutting between four semiconductor components.

3. Production of Four Semiconductor Devices Segmented into Pieces

The obtained first resin film-attached flexible substrate was cut into 4 pieces (segmented into pieces) and subsequently semiconductor chips (size: 10 mm × 10 mm × 0.2 mm) having solder bumps with a height of 25 $\mu$m and a pitch of 70 $\mu$m were respectively mounted on the surface of the first resin film under the conditions of a temperature of 120˚C, a period of 10 seconds and a pressure of 0.1 MPa for temporary connection. Next, the flexible substrates in which semiconductor components were temporarily connected to the surface of the first resin film were respectively heated at 230˚C for 30 seconds for carrying out solder connection. Then, the flexible substrates in which semiconductor components were solder-connected were heated at 180˚C for 60 minutes for thermally curing the first resin film, whereby four semiconductor devices were obtained.

Example 2

The same operation was carried out in the same manner as in Example 1, except that 45 % by weight of an epoxy resin, EPICLON 840-S (a product of DIC Corporation), 24.97 % by weight of a phenoxy resin, YX6954 (a product of Japan Epoxy Resin Co., Ltd.), 15 % by weight of a compound having flux activity, phenolphthalin (a product of Tokyo Chemical Industry Co., Ltd.), 15 % by weight of a phenol novolac resin, PR-53647 (a product of Sumitomo Bakelite Co., Ltd.) and 0.03 % by weight of a curing accelerator, 2P4MZ (a product of Shikoku Chemicals Corporation) were previously mixed as the first resin film, and the gel time of the first resin film at 230˚C was changed to 100 seconds. Furthermore, the melt viscosity of the first resin film at 120˚C was 5 Pa·s, while the reduction retention rate was 50%.

Example 3

The same operation was carried out in the same manner as in Example 1, except that as the second resin film, PIBO (polyimidebenzoxazole, a product of Toyobo Co., Ltd., coefficient of thermal expansion: 2.5 ppm, thickness: 25 $\mu$m) was used, and a copper clad polyimide film with a two-layer structure having a 9 $\mu$m thick copper layer formed on PIBO was used.

Example 4

The same operation was carried out in the same manner as in Example 1, except that 49.9 % by weight of an epoxy resin, EPICLON 840-S (a product of DIC Corporation), 20 % by weight of a phenoxy resin, YX6954 (a product of Japan Epoxy Resin Co. , Ltd.), 14 % by weight of a compound having flux activity, phenolphthalin (a product of Tokyo Chemical Industry Co., Ltd.), 16 % by weight of a phenol novolac resin, PR-53647 (a product of Sumitomo Bakelite Co., Ltd.) and 0.1 % by weight of a curing accelerator, 2P4MZ (a product of Shikoku Chemicals Corporation) were previously mixed as the first resin film, and the gel time of the first resin film at 230˚C was changed to 150 seconds. Furthermore, the melt viscosity of the first resin film 1 at 120˚C was 0.5 Pa·s, while the reduction retention rate was 85%.

Comparative Example 1

The same operation was carried out in the same manner as in Example 1, except that a rigid substrate, BT substrate (Model: HL832HS-TypeHS, a product of Mitsubishi Gas Chemical Company, Inc., coefficient of thermal expansion: 15 ppm, thickness: 50 $\mu$m) was used as the second resin film, whereas a semiconductor device having fine wiring corresponding to the solder bumps as described above was not obtained.

Comparative Example 2

The same operation was carried out in the same manner as in Example 1, except that the following first resin film without having flux activity was used.

The first resin film containing 55 % by weight of EPICLON 840-S (a product of DIC Corporation), 30 % by weight of YX6954 (a product of Japan Epoxy Resin Co., Ltd.), 14.9 % by weight of PR-53647 (a product of Sumitomo Bakelite Co., Ltd.) and 0.1 % by weight of 2P4MZ (a product of Shikoku Chemicals Corporation) without containing phenolphthalin which were previously mixed was used. The gel time of the first resin film at 230˚C was 140 seconds, while the melt viscosity at 120˚C was 30 Pa·s.

Comparative Example 3

The same operation was carried out in the same manner as in Example 1, except that only the second resin film and the semiconductor chips were connected using an underfill (Model: CRP-4160E, a product of Sumitomo Bakelite Co., Ltd.). However, since a gap between the semiconductor chips and the flexible substrate was narrow, injection of the underfill was not sufficient.

Comparative Example 4

The same operation was carried out in the same manner as in Example 1, except that 45 % by weight of an epoxy resin, EPICLON 840-S (a product of DIC Corporation), 24.9 % by weight of a phenoxy resin, YX6954 (a product of Japan Epoxy Resin Co. , Ltd.), 15 % by weight of a compound having flux activity, phenolphthalin (a product of Tokyo Chemical Industry Co., Ltd.), 15 % by weight of a phenol novolac resin, PR-53647 (a product of Sumitomo Bakelite Co., Ltd.) and 0.1 % by weight of an imidazole compound, 2MZ (a product of Shikoku Chemicals Corporation) were previously mixed as the first resin film, and the gel time of the first resin film at 230˚C was changed to 60 seconds. Furthermore, the melt viscosity of the first resin film at 120 ˚C was 5 Pa·s, while the reduction retention rate was 80%.

Comparative Example 5

The same operation was carried out in the same manner as in Example 1, except that 54.9 % by weight of an epoxy resin, EPICLON 840-S (a product of DIC Corporation), 24 % by weight of a phenoxy resin, YX6954 (a product of Japan Epoxy Resin Co., Ltd.), 5 % by weight of a compound having flux activity, 2,4-dihydroxybenzoic acid (a product of Tokyo Chemical Industry Co., Ltd.), 16 % by weight of a phenol novolac resin, PR-53647 (a product of Sumitomo Bakelite Co., Ltd.) and 0.1 % by weight of an imidazole compound, 2P4MZ (a product of Shikoku Chemicals Corporation) were previously mixed as the first resin film, and the gel time of the first resin film at 230˚C was changed to 120 seconds. Furthermore, the melt viscosity of the first resin film at 120˚C was 5 Pa·s, while the reduction retention rate was 10%.
First resin films and semiconductor devices obtained in respective Examples and Comparative Examples were evaluated in the following manner. Evaluation items are illustrated along with the contents. The obtained results are shown in Table 1. Incidentally, in Table 1, flexible refers to a flexible substrate, while rigid refers to a rigid substrate.

1. Connectivity

For the connectivity evaluation, the connected packages were subjected to cross-section polishing, and those having bumps in which a connection failure occurred to any one of packages were determined as NG. Four packages were evaluated in terms of the number of packages in which a connection failure did not occur.

2. Reflow Resistance

For the reflow resistance evaluation, after a moisture absorption treatment at 30˚C and 60% for 96 hours, the presence of peeling was confirmed with a scanning acoustic microscopy after packages were passed through the reflow having a maximum temperature of 260˚C three times. Four packages were evaluated in terms of the number of packages in which peeling did not occur.

3. Resistance of Temperature Cycling Test

For the resistance of temperature cycling test, a connection resistance was monitored after 500 cycles for the temperature cycling test under the conditions of -40˚C and 125˚C (30 minute hold time). The connection resistance which was increased by 15% as compared to the initial resistance value was evaluated as extraordinary resistance.

Four packages were evaluated in terms of the number of packages in which the initial resistance value was not increased by 15%.

4. Productivity

The process step and time period involved from the preparation of each member to the production of packages were roughly estimated to evaluate the productivity. Respective numerals are as follows:

   ○: Exhibiting excellent productivity.
   ×: Exhibiting low productivity.

5. Melt Viscosity of First Resin Film at 120˚C

The melt viscosity of an adhesive film was measured under the conditions of a parallel plate of 20 mmφ, a gap of 0.05 mm, a frequency of 0.1 Hz and a temperature increase rate of 10˚C/minute using a rheometer (RheoStress RS150, a product of Haake Co., Ltd.). The melt viscosity at 120˚C was measured.

6. Reduction Retention Rate of First Resin Film

0.1 g to 0.2 g of the first resin film subjected to heat treatment at 100˚C for 30 minutes and the first resin film without heat treatment were respectively accurately weighed, and then dissolved in 100 ml of acetone to prepare a measurement sample. Subsequently, the molar amount (reductivity, unit: mol/g) of the acid per unit weight was calculated by performing a titration with 0.05 mol/l of an aqueous sodium hydroxide solution in a room temperature (23˚C) atmosphere using an automatic potentiometric titrator (Model: AT-500N, a product of Kyoto Electronics Manufacturing Co., Ltd.). Furthermore, the reduction retention rate was calculated according to the following equation 1,

```
[Equation 1]

Reduction Retention Rate (%) = {(Amount of acid in the first resin film subjected to heat treatment at 100°C for

30 minutes)/(Amount of acid in the first resin film without

heat treatment)} × 100
```

7. Gel Time

It was measured in accordance with JIS C2161 7.5.2.
[Table 1]

[Table 1]

| | | Example 1 | Example 2 | Example 3 | Example 4 | Comparative Example 1 | Comparative Example 2 | Comparative Example 3 | Comparative Example 4 | Comparative Example 5 |
|---|---|---|---|---|---|---|---|---|---|---|
| First Resin Film | Gel time at 230°C (sec) | 140 | 100 | 140 | 150 | 140 | 140 | - | 60 | 120 |
| | Melt viscosity at 120°C (Pa·s) | 50 | 5 | 5 | 0.5 | 5 | 30 | - | 5 | 5 |
| | Flux activity | Yes | Yes | Yes | Yes | Yes | No | - | Yes | Yes |
| | Reduction retention rate (%) | 90 | 50 | 90 | 85 | 90 | - | - | 80 | 10 |
| | Coefficient of thermal expansion ($\leq Tg$) (ppm) | 11 | 11 | 2.5 | 11 | 15 | 11 | 11 | 11 | 11 |
| Second Resin Film | Substrate kind | Flexible | Flexible | Flexible | Flexible | Rigid | Flexible | Flexible | Flexible | Flexible |
| | Thickness ($\mu$m) | 25 | 25 | 25 | 25 | 50 | 25 | 25 | 25 | 25 |
| Connectivity (4 at a time) (No. of 100% connected packages/ No. of total packages) | | 4/4 | 4/4 | 4/4 | 4/4 | - | 2/4 | 4/4 | 1/4 | 2/4 |
| Segmented connectivity (No. of 100% connected packages / No. of total packages) | | 4/4 | 4/4 | 4/4 | 4/4 | - | 2/4 | 4/4 | 4/4 | 4/4 |
| Reflow resistance (No. of 100% connected packages / No. of total packages) | | 4/4 | 4/4 | 4/4 | 4/4 | - | 2/2 | 0/4 | 1/1 | 2/2 |
| Temperature cycling resistance (No. of 100% connected packages/ No. of total packages) | | 4/4 | 4/4 | 4/4 | 4/4 | - | 1/2 | 0/4 | 1/1 | 2/2 |

(continued)

| | Example 1 | Example 2 | Example 3 | Example 4 | Comparative Example 1 | Comparative Example 2 | Comparative Example 3 | Comparative Example 4 | Comparative Example 5 |
|---|---|---|---|---|---|---|---|---|---|
| Productivity | ○ | ○ | ○ | ○ | - | ○ | × | ○ | ○ |

As clear from Table 1, in Examples 1 to 4, fine wiring could be formed and the connectivity was also excellent. Moreover, in Examples 1 to 4, the reflow resistance and the temperature cycling resistance were also excellent.
In Examples 1 to 4, the productivity was also excellent.
In Comparative Example 4 in which the gel time of the first resin film at 230˚C was 60 seconds, the segmented connectivity was excellent, whereas the connectivity of four packages bonded at one time was low. Furthermore, in Comparative Example 5 in which the reduction retention rate of the first resin film was 10%, the segmented connectivity was excellent, whereas the connectivity of four packages bonded at one time was low.
As described above, the embodiments of the present invention has been described, but the embodiments are examples of the present invention and other various constructions can also be adopted.

**Claims**

1. A flexible substrate comprising a first resin film having flux activity and a second resin film different from said first resin film laminated to said first resin film,
   wherein the flexible substrate is used by having a plurality of electronic components mounted on the surface of said first resin film, and thereafter having said respective electronic components and the flexible substrate bonded at one time, and
   a gel time of said first resin film at 230˚C is 100 seconds or more and 600 seconds or less.

2. The flexible substrate according to claim 1, wherein the reduction retention rate of said first resin film calculated according to an equation 1 from the amount of the acid measured under the following condition is not less than 15%,
   [Measurement Condition]
   0.1 g to 0.2 g of said first resin film subjected to heat treatment at 100˚C for 30 minutes and said first resin film without heat treatment are respectively accurately weighed, and dissolved in 100 ml of acetone to perform a titration with an aqueous sodium hydroxide solution in accordance with a potential difference measuring method for calculating the molar amount (mol/g) of the acid per unit weight,

   [Equation 1]

   $$\text{Reduction Retention Rate (\%)} = \{(\text{Amount of acid in said first resin film subjected to heat treatment at } 100°C \text{ for } 30 \text{ minutes})/(\text{Amount of acid in said first resin film without heat treatment})\} \times 100$$

3. The flexible substrate according to claim 1 or 2, wherein said first resin film is composed of a resin composition containing a thermosetting resin and a compound having flux activity.

4. The flexible substrate according to any one of claims 1 to 3, wherein said first resin film contains phenolphthalin.

5. The flexible substrate according to any one of claims 1 to 4, wherein the melt viscosity of said first resin film at 120˚C is 0.1 to 10,000 Pa·s.

6. The flexible substrate according to any one of claims 1 to 5, wherein the melt viscosity of said first resin film at 120˚C is 1 to 10,000 Pa·s.

7. The flexible substrate according to any one of claims 1 to 6, wherein said second resin film is provided with through holes, and said through holes are each filled with a conductor member.

8. The flexible substrate according to any one of claims 1 to 7, wherein conductor layers are formed on one surface of said second resin film, and bump electrodes are formed on the other surface thereof so as to cover the conductor members.

9. The flexible substrate according to any one of claims 1 to 8, wherein said second resin film is composed of at least one resin selected among a polyimide type resin, a polyester type resin, a polyamide type resin and a liquid crystal polymer.

10. The flexible substrate according to any one of claims 1 to 9, wherein the coefficient of thermal expansion of said second resin film at room temperature (23˚C) or more and the glass transition temperature of said second resin film or less is not more than 15 ppm.

11. The flexible substrate according to any one of claims 1 to 10, wherein the coefficient of thermal expansion of said second resin film at room temperature (23˚C) or more and the glass transition temperature of said second resin film or less is 3 ppm or more and 8 ppm or less.

12. An electronic device comprising the flexible substrate according to any one of claims 1 to 11.

13. A method for producing an electronic device comprising
mounting a plurality of electronic components on a surface of a first resin film of a flexible substrate obtained by laminating said first resin film having flux activity and a second resin film different from said first resin film, and thereafter bonding said respective electronic components and the flexible substrate bonded at one time, and segmenting said plurality of electronic components together with said flexible substrate into pieces after bonding, in which said flexible substrate is the flexible substrate according to any one of claims 1 to 11.

[Fig. 1]

[Fig. 2]

(a)

(b)

(c)

(d)

[Fig. 3]

(a)

(b)

| INTERNATIONAL SEARCH REPORT | International application No. |
|---|---|
| | PCT/JP2009/007145 |

A.   CLASSIFICATION OF SUBJECT MATTER
*H05K3/34*(2006.01)i, *B32B27/00*(2006.01)i

According to International Patent Classification (IPC) or to both national classification and IPC

B.   FIELDS SEARCHED

Minimum documentation searched (classification system followed by classification symbols)
H05K3/34, B32B27/00

Documentation searched other than minimum documentation to the extent that such documents are included in the fields searched
| Jitsuyo Shinan Koho | 1922-1996 | Jitsuyo Shinan Toroku Koho | 1996-2010 |
| Kokai Jitsuyo Shinan Koho | 1971-2010 | Toroku Jitsuyo Shinan Koho | 1994-2010 |

Electronic data base consulted during the international search (name of data base and, where practicable, search terms used)

C.   DOCUMENTS CONSIDERED TO BE RELEVANT

| Category* | Citation of document, with indication, where appropriate, of the relevant passages | Relevant to claim No. |
|---|---|---|
| Y | JP 2002-241617 A  (Nitto Denko Corp.),<br>28 August 2002 (28.08.2002),<br>claim 1; paragraphs [0018], [0032] to [0037];<br>fig. 1, 2<br>& US 6617046 B2          & EP 1233446 A2<br>& DE 60200455 T          & TW 574739 B<br>& HK 1050543 A           & KR 10-2002-0067436 A<br>& CN 1375521 A           & SG 111042 A | 1-13 |
| Y | JP 2005-59028 A  (Toshiba Corp.),<br>10 March 2005 (10.03.2005),<br>paragraphs [0016], [0023], [0050]<br>& US 2005/0056687 A1     & US 2007/0221712 A1<br>& CN 1579698 A | 1-13 |

| ☒ Further documents are listed in the continuation of Box C. | ☐ See patent family annex. |
|---|---|

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 19 January, 2010 (19.01.10) | 02 February, 2010 (02.02.10) |

| Name and mailing address of the ISA/ | Authorized officer |
|---|---|
| Japanese Patent Office | |
| Facsimile No. | Telephone No. |

Form PCT/ISA/210 (second sheet) (April 2007)

**INTERNATIONAL SEARCH REPORT**

International application No.

PCT/JP2009/007145

C (Continuation).    DOCUMENTS CONSIDERED TO BE RELEVANT

| Category* | Citation of document, with indication, where appropriate, of the relevant passages | Relevant to claim No. |
|---|---|---|
| Y | JP 11-307586 A  (Matsushita Electric Works, Ltd.), 05 November 1999 (05.11.1999), paragraphs [0023] to [0025]; fig. 4 (Family: none) | 1-13 |
| Y | JP 2002-224886 A  (Sumitomo Bakelite Co., Ltd.), 13 August 2002 (13.08.2002), paragraph [0025] (Family: none) | 2-13 |
| Y | JP 2008-177502 A  (Toyobo Co., Ltd.), 31 July 2008 (31.07.2008), claim 1; paragraphs [0002], [0005] (Family: none) | 10-13 |
| A | WO 2005/027601 A1  (Taiyo Ink Manufacturing Co., Ltd.), 24 March 2005 (24.03.2005), paragraphs [0050], [0051] & CN 1849854 A | 1-13 |
| A | JP 62-11294 A  (Nikkan Industries Co., Ltd.), 20 January 1987 (20.01.1987), claims (Family: none) | 1-13 |

Form PCT/ISA/210 (continuation of second sheet) (April 2007)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP HEI91997246326 B

- JP 2005116624 A